# EUROPEAN PATENT APPLICATION

(11) **EP 4 793 597 A2**
(43) Date of publication of application: **19.08.2026**
(21) Application number: 26158420.5
(22) Date of filing: 13.02.2026
(51) Int. Cl.: G01C 19/5733, G01C 19/5747

(54) **MEMS DEVICE HAVING A DAMPING AND STOPPING MULTIFUNCTION STRUCTURE**

(30) Priority: 18.02.2025 IT 202500003153
(71) Applicant: STMicroelectronics International N.V., 1228 Plan-les-Ouates, Geneva (CH)
(72) Inventor: CARULLI, Paola, 20864 AGRATE BRIANZA (MB) (IT); FEDELI, Patrick, 20864 AGRATE BRIANZA (MB) (IT); FALORNI, Luca Giuseppe, 20864 AGRATE BRIANZA (MB) (IT)
(74) Representative: Studio Torta S.p.A.

(57) **Abstract**

A microelectromechanical device (1) includes: a support body (2); a movable mass (Y4), constrained to the support body (2) with a relative degree of freedom with respect to at least a first direction (Y) parallel to the support body (2), and comprising a frame portion (6) delimiting an opening (7); and a damping and stopping structure (5), anchored to the support body (2) and accommodated in the opening (7) of the movable mass (Y4). The movable mass (Y4) comprises a plurality of first elongated elements (65) defined by respective plates perpendicular to the first direction (Y) and extending in the opening (7) from the frame portion (6) in a comb-like configuration. The damping and stopping structure (5) comprises a plurality of second elongated elements (55) anchored to the support body (2), defined by respective plates perpendicular to the first direction (Y) and extending towards the frame portion (6) of the movable mass (Y4) in a comb-like configuration. The second elongated elements (55) are interdigitated with the first elongated elements (65). The damping and stopping structure (5) further comprises a plurality of stopping elements (56) configured to limit movements of the movable mass (Y4) along at least the first direction (Y).

## Description

### Technical Field

The present invention relates to a microelectromechanical (MEMS) device, and in particular to a MEMS gyroscope, having a damping and stopping multifunction structure.

### Background

As is known, many MEMS devices exploit the movement of one or more movable structures (typically called "movable masses" or "proof masses"), with respect to a support body, either to sense variations in a physical quantity - MEMS devices such as inertial sensors - or to function as actuators.

In response to shocks that may occur during the life of MEMS devices, the movable masses may exceed the range of work positions considered safe. In order to avoid structural damage, stopping structures (also known as "stoppers") are envisaged able to limit the allowable displacements of the movable masses. The stopping structures are typically anchored to the support body through anchoring elements (or simply "anchors"). The anchors of the stopping structures need to be sufficiently robust from the mechanical point of view to withstand impacts between the stopping structures and the movable masses: this typically results in relatively large anchors.

In inertial sensors such as gyroscopes, movable masses are set to controlled oscillation along a driving direction and, in response to a rotation of the support body around a rotation axis perpendicular to the driving direction, are able to oscillate along a sensing direction perpendicular to the driving direction and the rotation axis. In order to preserve, in particular, the sensing response according to the design preferences, in gyroscopes it is essential to control the vibration immunity figure: a trade-off of the quality factor Q of the sensing transfer function is typically necessary in order to maintain, at the same time, the oscillation performance high (which would imply a high quality factor Q) and the vibration sensitivity low (which would imply a low quality factor Q).

A typical solution that allows the factor Q to be reduced in gyroscopes is to use damping structures (also known as "dampers"), coupled to the movable masses and to the support body and configured to reduce, through a mechanical damping action, the displacements of the movable masses along the sensing direction caused by vibrations. For example, for a gyroscope able to sense rotations around an "out-of-plane" rotation axis, known "in-plane" damping structures may be used. However, in order to be significantly effective, damping structures typically require a relatively large occupation area within the sensor.

Alternative solutions, such as that of carrying out the sealing operations of the sensors in chambers with high pressures and/or with specific gas mixtures, risk leading to a reduction also of the factor Q along the driving direction, which needs instead to be maintained high so as to allow the movable masses to remain correctly in controlled oscillation.

A disadvantage, therefore, of both stopping structures and damping structures in current MEMS gyroscopes is space consumption. More generally, such a disadvantage is present in MEMS devices - such as inertial sensors and actuators - which require stopping structures for the movable masses and damping structures for oscillations of the movable masses along at least one direction.

### Summary

It is therefore an aim of the present invention to overcome or at least partially mitigate the disadvantages and limitations of the state of the art.

According to the present invention, a MEMS device is presented having a damping and stopping multifunction structure as defined in the attached claims.

### Brief Description of the Figures

For a better understanding of the present invention, preferred embodiments are presented, by way of non-limiting example, with reference to the attached drawings, wherein:
- Figure 1 shows schematically in a plan view a MEMS device in accordance with an embodiment of the present invention and according to a driving mode;
- Figure 2 shows schematically in a plan view the MEMS device of Figure 1 according to the sensing modes;
- Figure 3 shows schematically in a plan view an enlarged portion of the MEMS device of Figure 1 in accordance with an embodiment of the present invention; and
- Figure 4 shows schematically in a plan view an enlarged portion of the MEMS device of Figure 1 in accordance with a different embodiment of the present invention.

### Description of Embodiments

The following description refers to the arrangement shown in the drawings; consequently, expressions such as "above", "below", "upper", "lower", "top", "bottom", "right", "left" and the like relate to the attached Figures and are not to be interpreted in a limiting manner.

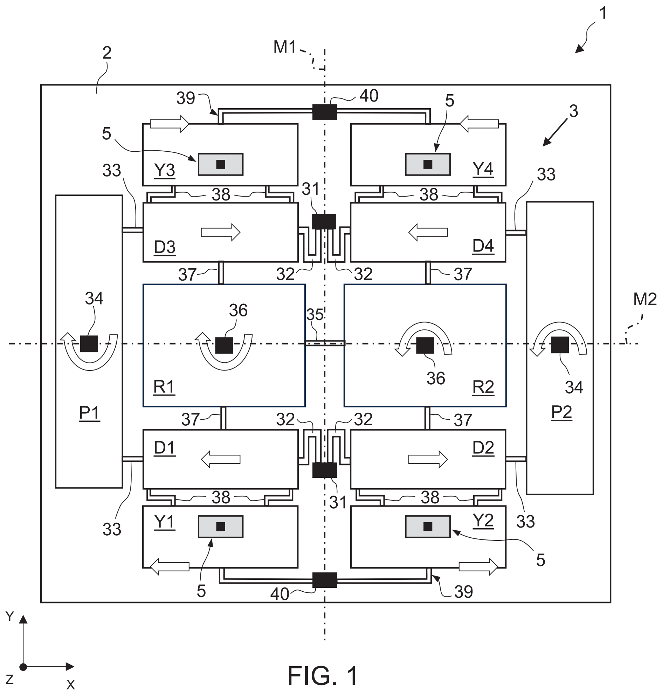

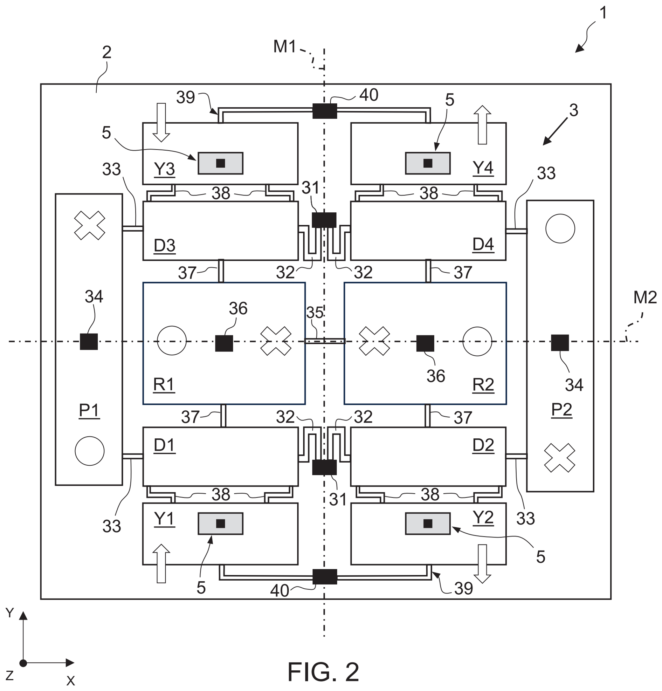

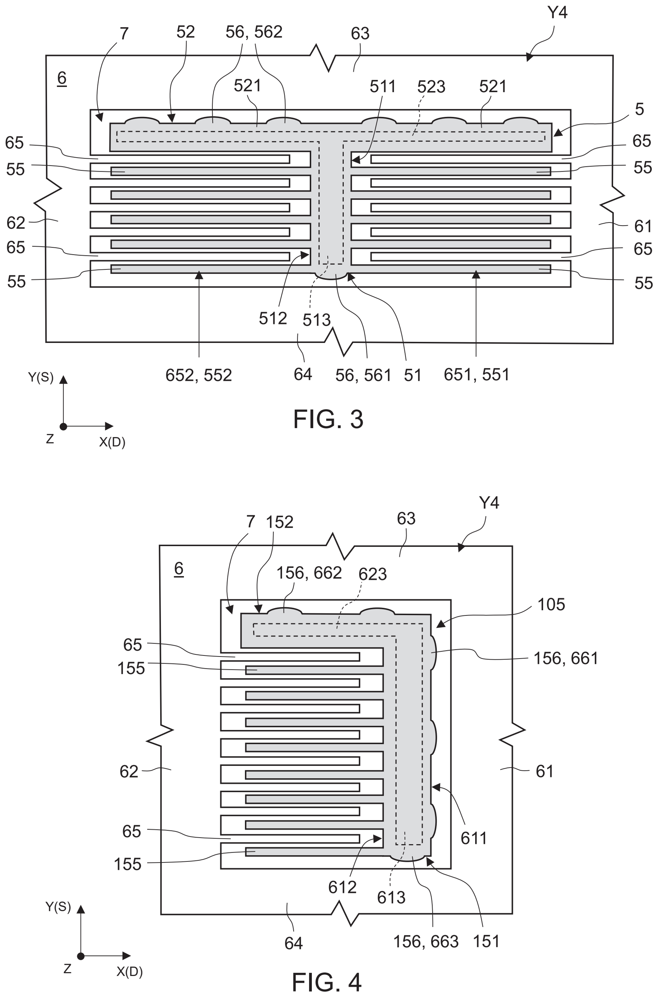

Figures 1 and 2 show a microelectromechanical (MEMS) device, hereinafter also simply "device", according to an embodiment of the present invention, indicated as a whole by the number 1 and comprising a support body 2 and a MEMS structure 3. In particular, without this being considered limiting, the device 1 described below and shown schematically in Figures 1 and 2 is a triaxial MEMS gyroscope (also configurable for six-axis inertial sensing); hereinafter, therefore, reference will be made interchangeably to device 1 as well as to gyroscope 1. However, it will be clear that what is described below, and in particular what is shown in Figures 3 and 4, may be applied to inertial MEMS devices other than the gyroscope 1 of Figures 1 and 2.

Considering a reference system of orthogonal axes X, Y, Z, the support body 2 and the MEMS structure 3 have a respective main extension parallel to the XY-plane. Furthermore, the MEMS structure 3 is symmetrical with respect to a first symmetry axis M1, parallel to the Y-axis, and with respect to a second symmetry axis M2, parallel to the X-axis. The support body 2 and the MEMS structure 3 are formed of semiconductor material, for example they are both of silicon. The MEMS structure 3 comprises a set of driving and sensing masses that are movable with respect to the support body 2, i.e. the movable masses of the MEMS structure 3 are constrained to the support body 2 with a relative degree of freedom with respect to at least one direction of motion.

The MEMS structure 3 comprises in detail a first driving mass D1 and a second driving mass D2, forming a first pair of driving masses D1, D2, arranged on a same side of the MEMS structure 3 with respect to the second symmetry axis M2 and aligned along the X-axis. The driving masses of the first pair D1, D2 are also coupled to a respective same driving anchor 31, each by means of a respective anchoring elastic element 32. The driving anchor 31 is fixed to the support body 2 and is arranged in a median position between the first and second driving masses D1, D2 along the first symmetry axis M1. The anchoring elastic elements 32 are for example of the folded or bellows type.

The MEMS structure 3 also comprises a third driving mass D3 and a fourth driving mass D4, forming a second pair of driving masses D3, D4, arranged on a second and same side of the MEMS structure 3 with respect to the second symmetry axis M2 and aligned along the X-axis. The driving masses of the second pair D3, D4 are in particular arranged in a symmetrical manner with respect to the driving masses of the first pair D1, D2 with respect to the second symmetry axis M2. The driving masses of the second pair D3, D4 are also coupled to a respective same driving anchor 31, each by means of a respective anchoring elastic element 32, in a completely symmetrical manner with respect to the driving masses of the first pair D1, D2. In particular, this driving anchor 31 is fixed to the support body 2 and is arranged in a median position between the third and fourth driving masses D3, D4 along the first symmetry axis M1.

In a manner not illustrated in detail here, the driving masses of the first and second pairs D1, D2, D3, D4 may each define therewithin windows or openings for movable driving electrodes, the latter coupled to the same masses (or in any case integral therewith) and interdigitated with corresponding fixed driving electrodes, also arranged within the same windows. In a manner known per se, the capacitive interaction between the interdigitated driving electrodes determines a driving movement of the MEMS structure 3, as described in more detail below. In particular, the driving movement for the driving masses of the first and second pairs D1, D2, D3, D4 occurs "in-plane", more in particular along the X-axis.

The MEMS structure 3 also comprises a first pitch sensing mass P1 and a second pitch sensing mass P2, forming a pair of pitch sensing masses P1, P2, arranged in a symmetrical manner with respect to the first symmetry axis M1 - externally with respect to the driving masses of the first and second pairs D1, D2, D3, D4 (along the X-axis) - and extending in length along the Y-axis traversing the second symmetry axis M2 (symmetrically with respect to the same second symmetry axis M2). The pitch sensing masses P1, P2 are used in the device 1 to sense a pitch angular velocity.

The first pitch sensing mass P1 is elastically coupled to both the first driving mass D1 and the third driving mass D3 (i.e. to the driving masses arranged on a same side of the MEMS structure 3 with respect to the first symmetry axis M1) through respective coupling elastic elements 33. Similarly, the second pitch sensing mass P2 is elastically coupled to both the second driving mass D2 and the fourth driving mass D4 through respective coupling elastic elements 33. Furthermore, the pitch sensing masses P1, P2 are elastically constrained to the support body 2 by means of respective pitch anchors 34, arranged centrally to the pitch sensing masses P1, P2 through specific windows not shown in detail in Figures 1 and 2. In particular, each pitch sensing mass P1, P2 is elastically connected to the respective pitch anchor 34 by means of an elastic coupling arrangement (also not shown in the attached Figures) which defines a rotation axis (here parallel to the X-axis) for the "out-of-plane" rotation with respect to the XY-plane of the same pitch sensing mass.

The coupling elastic elements 33 of the MEMS structure 3 are generically configured to convert the translational driving movement of the driving masses of the first and second pairs D1, D2, D3, D4 into a rotation movement in the XY-plane of the pitch sensing masses P1, P2 (around the respective pitch anchors 34), so as to allow the "out-of-plane" sensing movement thereof due to the Coriolis force in the presence of a pitch angular velocity around the Y-axis. In a non-limiting embodiment, the coupling elastic elements 33 each comprise, for example: a linear central portion that is elongated (in the example of Figure 1, along the X-axis) and rigid along the same direction in order to convert the driving movement of the respective driving masses to the pitch sensing mass; and end portions, arranged at the distal ends of the aforementioned central portion, coupled respectively to one of the driving masses and to the corresponding pitch sensing mass, elastic and yielding to "out-of-plane" movements with respect to the XY-plane and having for example a folded or bellows or serpentine shape along the X-axis.

Below the pitch sensing masses P1, P2 there are arranged (in a manner not illustrated in the attached Figures) respective fixed electrodes, capacitively coupled to the pitch sensing masses P1, P2 and placed above, or integral with, the support body 2 (so as to provide a differential pitch sensing scheme, of a type known per se, not described in detail here).

The MEMS structure 3 also comprises a first roll sensing mass R1 and a second roll sensing mass R2, forming a pair of roll sensing masses R1, R2. The roll sensing masses R1, R2 are arranged symmetrically to each other on opposite sides of the first symmetry axis M1 and are elastically connected to each other by means of a coupling elastic element 35, which is arranged along the second symmetry axis M2 and has a stiffness such as to allow the movement of the roll sensing masses R1, R2 (as will be described in detail below) and, at the same time, such as to maintain them constrained to each other in their movement. The roll sensing masses R1, R2 are arranged in a central position of the MEMS structure 3, internally to the driving masses of the first and second pairs D1, D2, D3, D4. The roll sensing masses R1, R2 are used in the device 1 to sense a roll angular velocity.

Each of the roll sensing masses R1, R2 has a shape, for example, substantially rectangular in-plan and has centrally a window (not illustrated for reasons of illustrative simplicity) having a respective roll anchor 36 arranged therewithin. Each of the roll sensing masses R1, R2 is coupled to the respective roll anchor 36 by means of an elastic coupling arrangement (not shown for illustrative simplicity) which defines a rotation axis (here parallel to the Y-axis) for the "out-of-plane" sensing movement with respect to the XY-plane.

Furthermore, the first roll sensing mass R1 is elastically coupled to the first and third driving masses D1, D3, by means of respective coupling elastic elements 37, which extend starting from respective opposite sides of the first roll sensing mass R1 and are aligned along the Y-axis. As shown schematically in Figures 1 and 2, such coupling elastic elements 37 may for example be of a linear type. Similarly, the second roll sensing mass R2 is elastically coupled to the second and fourth driving masses D2, D4, by means of respective coupling elastic elements 37, which extend starting from respective opposite sides of the second roll sensing mass R2 and are aligned along the Y-axis (being for example of a linear type).

Below the roll sensing masses R1, R2 there are arranged (in a manner not illustrated in the attached Figures) respective fixed electrodes, capacitively coupled to the roll sensing masses R1, R2 and placed above, or integral to, the support body 2 (so as to provide a differential roll sensing scheme, of a type known per se, not described in detail here).

The MEMS structure 3 finally comprises a first yaw sensing mass Y1 and a second yaw sensing mass Y2, forming a first pair of yaw sensing masses Y1, Y2, and a third yaw sensing mass Y3 and a fourth yaw sensing mass Y4, forming a second pair of yaw sensing masses Y3, Y4. In a non-limiting embodiment, each yaw sensing mass Y1, Y2, Y3, Y4 has a substantially quadrangular shape in-plan, for example rectangular with a long side parallel to the X-axis.

Each yaw sensing mass of the first pair Y1, Y2 is elastically coupled to a respective driving mass of the first pair of driving masses D1, D2 by means of respective coupling elastic elements 38 (in the example of Figures 1 and 2, in a number equal to two for each mass, interposed between end portions of the coupled driving masses and yaw sensing masses). Similarly, each yaw sensing mass of the second pair Y3, Y4 is elastically coupled to a respective driving mass of the second pair of driving masses D3, D4 by means of respective coupling elastic elements 38.

Furthermore, the yaw sensing masses of the first pair Y1, Y2, and the yaw sensing masses of the second pair Y3, Y4 are respectively coupled to each other by means of respective elastic coupling structures 39, which extend centrally to the MEMS structure 3 and along the X-axis, traversing the first symmetry axis M1. In detail, each elastic coupling structure 39 defines a lever elastic element, of the central fulcrum type, hinged to the support body 2 by means of a yaw anchor 40 and coupled at its ends to the respective yaw sensing masses that form the first pair Y1, Y2 or the second pair Y3, Y4.

The coupling elements 38 and the elastic coupling structures 39 therefore allow the yaw sensing masses Y1, Y2, Y3, Y4 to perform "in-plane" movements in the XY-plane, in particular sensing movements along the Y-axis (as shown in Figure 2 and as described in more detail below) in response to rotations of the device 1 around a rotation axis parallel to the Z-axis. That is, the yaw sensing masses Y1, Y2, Y3, Y4 are used in the device 1 to sense a yaw angular velocity.

In a manner not illustrated for reasons of simplicity of representation, the yaw sensing masses Y1, Y2, Y3, Y4 have internally - in respective sectors - windows for movable yaw sensing electrodes, coupled to the same masses (or in any case integral therewith) and alternating with corresponding fixed yaw sensing electrodes, so as to define a differential yaw sensing scheme.

According to one aspect of the present invention, the device 1 comprises a damping and stopping (or "multifunction") structure 5 associated with each yaw sensing mass Y1, Y2, Y3, Y4. As described in more detail below, each multifunction structure 5 is configured to implement both a damping function - along the Y-axis - and a stopping function - along the Y-axis and optionally also along the X-axis - for the corresponding yaw sensing mass Y1, Y2, Y3, Y4.

Again with reference to Figure 1, the driving masses D1, D2, D3, D4 of the MEMS structure 3 are driven (by means of the suitable polarization of the movable driving electrodes and the corresponding fixed driving electrodes) so as to perform a translation movement - in phase-opposition for each pair - along the X-axis. Furthermore, the movement of the driving masses of each pair symmetrical to each other with respect to the second symmetry axis M2 (i.e. the movement of the driving masses D1, D3 and D2, D4), is also in phase-opposition.

As highlighted by the arrows in Figure 1, the movement of the driving masses D1, D2, D3, D4 causes, due to the elastic couplings previously described, corresponding movements of the sensing masses. In particular, the roll sensing masses R1, R2 are dragged into a rotation in phase-opposition in the XY-plane, around an axis parallel to the Z-axis and passing through the center of the respective roll anchor 36. Furthermore, the yaw sensing masses Y1, Y2, Y3, Y4 are dragged by the associated respective driving masses D1, D2, D3, D4 into the same translation movement in phase-opposition along the X-axis. The movement of the driving masses D1, D2, D3, D4 also causes, due to the coupling elastic elements 33 (which operate as previously described in detail), a rotation in phase-opposition of the pitch sensing masses P1, P2, around an axis parallel to the Z-axis and passing through the center of the respective pitch anchor 34.

The driving movements described above therefore occur entirely "in-plane" in the XY-plane and do not involve further elements of the MEMS structure 3 of the gyroscope 1.

In Figure 2, the sole sensing movements performed by the sensing masses of the MEMS structure 3 in the presence of corresponding angular velocities are schematically represented (through arrows). In particular, in the presence of a pitch angular velocity around the Y-axis, the sensing movements of the MEMS structure 3 are "out-of-plane" rotations in phase-opposition with respect to the XY-plane of the pitch sensing masses P1, P2, around a rotation axis parallel to the X-axis. In the presence of a roll angular velocity around the X-axis, the sensing movements of the MEMS structure 3 are "out-of-plane" rotations in phase-opposition with respect to the XY-plane of the roll sensing masses R1, R2 around a rotation axis parallel to the Y-axis. In the presence of a yaw angular velocity around the Z-axis, the sensing movements of the MEMS structure 3 are displacements in phase-opposition of the yaw sensing masses Y1, Y2, Y3, Y4 of each pair along the Y-axis. Furthermore, the movements of the yaw sensing masses of each pair symmetrical to each other with respect to the second symmetry axis M2 (i.e. the movement of the yaw sensing masses Y1, Y3 and Y2, Y4), are also in phase-opposition. These movements also entail rotations in the XY-plane around the respective yaw anchor 40 of the lever elastic elements of the elastic coupling structures 39 that couple to each other the yaw sensing masses symmetrical with respect to the first symmetry axis M1. As anticipated, movable yaw electrodes (not illustrated in the attached Figures) move along the Y-axis with respect to corresponding fixed yaw electrodes respectively facing and the capacitance between the movable yaw electrodes and the fixed yaw electrodes varies accordingly.

In the MEMS structure 3 of the device 1, advantageously, the sensing movements of the yaw, roll and pitch sensing masses are completely independent of each other and do not have any mutual influences, effectively making the interference between the sensing axes of the gyroscope 1 (so-called cross-axis interference) substantially zero or in any case negligible. In particular, the driving masses D1-D4 essentially function as decoupling elements between the various sensing masses, which are in fact all connected to the sole driving masses D1-D4, essentially without mutual connections (and interference), and are actuated by the same driving masses D1-D4 with a single driving mode. Furthermore, the differential sensing scheme adopted allows to eliminate the effects related to both linear disturbance vibrations and angular disturbance vibrations.

With reference now also to Figure 3, one of the damping and stopping structures 5 of the device 1 is described below, for example the damping and stopping structure 5 associated with the fourth yaw sensing mass Y4; the same considerations also apply to the other damping and stopping structures 5 and to the associated yaw sensing masses Y1, Y2, Y3, taking into account the symmetries of the MEMS structure 3 with respect to the first and second symmetry axes M1, M2. Furthermore, hereinafter, for the sake of brevity, the fourth yaw sensing mass Y4 associated with the damping and stopping structure 5 in question will be referred to simply as movable mass Y4. In addition, hereinafter, referring to the sole yaw sensing masses, the X-axis will also be referred to as the driving axis and the direction therefrom will be referred to as the driving direction X, while the Y-axis will also be referred to as the sensing axis and the direction therefrom will be referred to as the sensing direction Y. The driving masses D1, D2, D3, D4 therefore act as actuators for the movable mass Y4, i.e. the driving masses D1, D2, D3, D4 are configured to maintain the movable mass Y4 in oscillation along the driving direction X.

As anticipated, the movable mass Y4 is elastically constrained to the support body 2 with a relative degree of freedom with respect to the driving direction X and with a relative degree of freedom with respect to the driving direction Y. The movable mass Y4 comprises in detail a frame portion 6 delimiting a through opening 7 where the damping and stopping structure 5 is accommodated.

The movable mass Y4 further comprises a plurality of first elongated elements, or fingers, 65 defined by plates perpendicular to the Y-axis which extend in a comb-like fashion from the frame portion 6 towards the center of the opening 7 and have a larger dimension parallel to the driving direction X. In more detail, the plurality of first elongated elements 65 of the movable mass Y4 of Figure 3 comprises a first group 651 of first elongated elements 65 and a second group 652 of first elongated elements 65. The first elongated elements of the first group 651 extend from a first side 61 of the frame portion 6, while the first elongated elements of the second group 652 extend from a second side 62 of the frame portion 6 opposite to the first side 61 along the X-axis. In a non-limiting manner, each first elongated element of the first group 651 is aligned, along the driving direction X, with a respective first elongated element of the second group 652. In the non-limiting embodiment of Figure 3, the first elongated elements of the first group 651 and the first elongated elements of the second group 652 all have a same length along the X-axis.

The first elongated elements 65 are therefore rigidly fixed to the frame portion 6 of the movable mass Y4 and follow - in use of the device 1 - the driving and sensing movements thereof described above.

The damping and stopping structure 5 is anchored to the support body 2 (as also schematically represented in Figures 1 and 2) and is accommodated in the opening 7 of the movable mass Y4. In a non-limiting embodiment, the damping and stopping structure 5 comprises a first anchor 51, a second anchor 52, a plurality of second elongated elements, or fingers, 55 and a plurality of stopping elements 56. The damping and stopping structure 5 is static in use and is separated from the movable mass Y4, with which it comes into contact only in a stopping condition of the movable mass Y4, as explained in more detail below.

The first anchor 51 has an elongated shape parallel to the sensing direction Y, for example it has a shape, in-plan, that is rectangular. The first anchor 51 is arranged between, and at a distance from, the first group 651 of first elongated elements 65 and the second group 652 of first elongated elements 65 of the movable mass Y4. In one embodiment, the first anchor 51 is arranged in a substantially central position of the opening 7. The first anchor 51 has in particular a first side 511, arranged facing the first side 61 of the frame portion 6, and a second side 512, arranged facing the second side 62 of the frame portion 6. Furthermore, the first anchor 51 comprises a base 513 by means of which it is anchored to the support body 2; the base 513 has for example an extension (parallel to the XY-plane) smaller than the remaining part of the first anchor 51, as shown in the non-limiting embodiment of Figure 3, which is therefore for example suspended with respect to the support body 2. In an alternative embodiment (not shown), the base 513 instead has an extension equal to the entire extension of the first anchor 51.

In one embodiment, the second anchor 52 has an elongated shape parallel to the driving direction X, for example it has a shape, in-plan, that is rectangular. The first anchor 51 and the second anchor 52 form for example a single body. The second anchor 52 of the damping and stopping structure 5 comprises in detail two lateral arms 521 which extend in opposite directions from the first anchor 51 parallel to the X-axis. The first and second anchors 51, 52 therefore form a "T" structure of the damping and stopping structure 5. In more detail, the second anchor 52 is arranged adjacent and substantially parallel to a third side 63 of the frame portion 6 of the movable mass Y4. The second anchor 52 and the third side 63 are substantially parallel to the X-axis. Furthermore, the overall length (along the X-axis) of the second anchor 52 is comparable to the respective length of the third side 63 of the frame portion 6, improving, as will become clearer below, the stopping action of the movable mass Y4 operated by the damping and stopping structure 5. The second anchor 52 also comprises a base 523 by means of which it is anchored to the support body 2; the base 523 has, for example, an extension (parallel to the XY-plane) smaller than the remaining parts of the second anchor 52, as shown in the non-limiting embodiment of Figure 3, which are therefore, for example, suspended with respect to the support body 2. In an alternative embodiment (not shown), the base 523 instead has an extension equal to the entire extension of the second anchor 52. The bases 513 and 523 form, for example, a single body.

The second elongated elements 55 are also defined by plates perpendicular to the Y-axis which extend in a comb-like fashion from the first anchor 51 towards the first and second sides 61, 62 of the frame portion 6 and have a larger dimension parallel to the driving direction X. The plurality of second elongated elements 55 of the damping and stopping structure 5 comprises a first group 551 of second elongated elements 55 and a second group 552 of second elongated elements 55. The second elongated elements 55 of the first group 551 extend in the opposite direction to the second elongated elements 55 of the second group 552. In detail, the second elongated elements of the first group 551 extend from the first side 511 of the first anchor 51, while the second elongated elements of the second group 552 extend from the second side 512 of the first anchor 51. In a non-limiting manner, each second elongated element of the first group 551 is aligned, along the driving direction X, with a respective second elongated element of the second group 552. In the non-limiting embodiment of Figure 3, the second elongated elements of the first group 551 and the second elongated elements of the second group 552 all have a same length along the X-axis. Furthermore, the second elongated elements 55, being supported by the first anchor 51, may be provided so as to be entirely suspended with respect to the support body 2.

The first elongated elements 65 of the first group 651 and the second elongated elements 55 of the first group 551 are interdigitated. Similarly, the first elongated elements 65 of the second group 652 and the second elongated elements 55 of the second group 552 are interdigitated. First elongated elements 65 and second elongated elements 55 mutually facing are spaced apart and separated by a gap having a width greater than the distance at rest between the stopping elements 56 and the frame portion 6, so as to avoid contact between the first elongated elements 65 and the second elongated elements 55.

In the damping and stopping structure 5, the second anchor 52 (and in particular the two lateral arms 521) faces, on the side opposite to that arranged facing the third side 63 of the frame portion 6, towards the first and second elongated elements 65, 55. In other words, the "T" structure of the damping and stopping structure 5 internally encloses the first and second elongated elements 65, 55. In the non-limiting embodiment of Figure 3, for example, the lateral arms 521 are internally facing and adjacent to respective first elongated elements 65 of the movable mass Y4. Furthermore, again in a non-limiting manner, the lateral arms 521 have a length (along the X-axis) such that respective projections along the Y-axis are level with free ends of the second elongated elements 55.

As anticipated for the first elongated elements 65 of the movable mass Y4, the second elongated elements 55 of the damping and stopping structure 5 also have a length (along the X-axis) such as not to mechanically interfere with the movements of the movable mass Y4. In particular, the length of the second elongated elements 55 is such as to leave sufficient clearance and allow, in use, the driving movement of the movable mass Y4 without the second elongated elements 55 and the movable mass Y4 coming into contact. In other words, corresponding free ends of the second elongated elements 55 are at a distance from the respective first and second sides 61, 62 of the frame portion 6. The shape of the damping and stopping structure 5 of the present invention is in general such as to correctly guarantee the driving movements of the MEMS structure 3.

The second elongated elements 55 are, as is the entire damping and stopping structure 5, static in use of the device 1. Furthermore, as mentioned, the second elongated elements 55 of the damping and stopping structure 5 are arranged interdigitated with the first elongated elements 65 of the movable mass Y4. According to one aspect of the present invention, the first elongated elements 65 of the movable mass Y4 and the second elongated elements 55 of the damping and stopping structure 5 form a viscous damper for the movable mass Y4 (i.e. for the yaw sensing mass Y4) along the sensing direction Y. In particular, in the device 1 of the present invention, a damping effect of the oscillations along the sensing direction Y is achieved by virtue of the viscous friction that the movements of the first elongated elements 65 of the movable mass Y4 towards the second elongated elements 55 of the damping and stopping structure 5 create with the gas mixture contained in a chamber (not shown) that accommodates the gyroscope 1.

The stopping elements 56 of the damping and stopping structure 5 are configured to limit the movements of the movable mass Y4 along the sensing direction Y, i.e. to limit the sensing oscillations of the yaw sensing mass Y4. In detail, the stopping elements 56 comprise respective contact portions - for example in the form of "bumpers" - protruding towards the frame portion 6 of the movable mass Y4. In more detail, the plurality of stopping elements 56 comprises first stopping elements 561 (one shown in Figure 3), protruding from the first anchor 51, and second stopping elements 562 (six shown in Figure 3), protruding from the second anchor 52. The first stopping elements 561 protrude towards a fourth side 64 (opposite to the third side 63 along the Y-axis) of the frame portion 6, while the second stopping elements 562 protrude towards the third side 63 of the frame portion 6. The stopping elements 56 are arranged and shaped so as not to hinder the sensing movements of the movable mass Y4, in conditions of use of the device 1 for which the sensing movements remain within a range of work positions considered safe. Furthermore, the first stopping elements 561 protrude from the first anchor 51 towards the fourth side 64 of the frame portion 6 more than second elongated elements 55 external and arranged facing the fourth side 64 of the frame portion 6.

With reference now to Figure 4, a damping and stopping structure is described in accordance with a different embodiment of the present invention and indicated by the number 105. The damping and stopping structure 105, and the associated movable mass Y4, are described below with reference to the sole differences with respect to the damping and stopping structure 5 and the movable mass Y4 of Figure 3. Furthermore, elements of the damping and stopping structure 105 that correspond to elements of the damping and stopping structure 5 of Figure 3 are indicated with the same reference numbers increased by one hundred; elements of the movable mass Y4 of Figure 4 that correspond to elements of the movable mass Y4 of Figure 3 are indicated with the same reference numbers.

In detail, the plurality of first elongated elements 65 of the movable mass Y4 of Figure 4 comprises a single group of first elongated elements 65 which extend starting from the second side 62 of the frame portion 6 towards the center of the opening 7, in a manner similar to what has been previously described.

The damping and stopping structure 105 comprises a first anchor 151, a second anchor 152, a plurality of second elongated elements, or fingers, 155 and a plurality of stopping elements 156.

The first anchor 151 is similar in shape to the first anchor 51 of the damping and stopping structure 5 of Figure 3 and is arranged adjacent and substantially parallel to the first side 61 of the frame portion 6 of the movable mass Y4. Furthermore, the overall length (along the Y-axis) of the first anchor 151 is comparable to the respective length of the first side 61 of the frame portion 6. The first anchor 151 has in particular a first side 611, arranged facing the first side 61 of the frame portion 6, and a second side 612, arranged facing the second side 62 of the frame portion 6. Finally, the first anchor 151 comprises a base 613 by means of which it is anchored to the support body 2, the base 613 being able to have an extension (in the XY-plane) smaller than the entire extension of the first anchor 151.

The second anchor 152 is arranged adjacent and substantially parallel to the third side 63 of the frame portion 6 of the movable mass Y4. Furthermore, the overall length (along the X-axis) of the second anchor 152 is comparable to the respective length of the third side 63 of the frame portion 6. In detail, the second anchor 152 comprises a single arm connected to one end of the first anchor 151 and which extends, along the X-axis, only starting from a part of the first anchor 151 (i.e. towards the second side 62 of the frame portion 6). The first and second anchors 151, 152 therefore form an "L" structure (reversed in Figure 4) of the damping and stopping structure 105. Finally, the second anchor 152 comprises a base 623 by means of which it is anchored to the support body 2, the base 623 being able to have an extension (in the XY-plane) smaller than the entire extension of the second anchor 152.

The plurality of second elongated elements 155 of the damping and stopping structure 105 comprises a single group of second elongated elements 155 which extend from the second side 612 of the first anchor 151 towards the center of the opening 7, and therefore towards the second side 62 of the frame portion 6. The second elongated elements 155 are arranged interdigitated with the first elongated elements 65 of the movable mass Y4.

The stopping elements 156 of the damping and stopping structure 105 are configured to limit the movements of the movable mass Y4 not only along the sensing direction Y but also along the driving direction X. In detail, the plurality of stopping elements 156 comprises: first stopping elements 661 (three shown in Figure 4), protruding from the first anchor 151 towards the first side 61 of the frame portion 6; second stopping elements 662 (two shown in Figure 4), protruding from the second anchor 152 towards the third side 63 of the frame portion 6; and optionally also third stopping elements 663 (one shown in Figure 4), protruding from the first anchor 151 towards the fourth side 64 of the frame portion 6. In more detail, the second stopping elements 662 and the third stopping elements 663 are configured to limit the movements of the movable mass Y4 along the sensing direction Y, while the first stopping elements 661 are configured to limit the movements of the movable mass Y4 along the driving direction X. The third stopping elements 663 of the damping and stopping structure 105 are effectively similar to the first stopping elements 561 of the damping and stopping structure 5 of Figure 3.

The damping and stopping structure of the present invention therefore allows to advantageously integrate in a single solution, being compact and having a limited area occupation, both a damping and a stopping action of the movable mass to which it is associated, along the same direction (in the examples shown, the sensing direction). In particular, the damping and stopping structure combines the stator portion of a viscous damper and stopping elements at least for the sensing direction. Even more in particular, in the damping and stopping structure of the present invention the first and second anchors may be provided with dimensions comparable to the dimensions of the sides of the frame portion of the movable mass to which they are adjacent, effectively obtaining an advantageously wide stopping area. Furthermore, the shapes of the damping and stopping structure described above ("T shape" and "L shape") allow to exploit the maximum possible anchoring area to the support body. Ultimately, the damping and stopping structure of the present invention allows to obtain an improved mechanical robustness with respect to shocks of the MEMS device and a combined reduction of the quality factor Q along a sensing direction in order to improve the vibration immunity of the same device.

Even more in particular, the damping and stopping structure of the present invention provides a possibility of design compromise between the damping and stopping requirements of the movable mass. For example, the damping and stopping structure 5 of Figure 3 allows a high damping area to be obtained, implementing a damping structure that is double and symmetrical with respect to the first anchor 51. The damping and stopping structure 105 of Figure 4 instead allows the stopping action to be more privileged, introducing the stopping action also along the driving direction X, maintaining the damping area more compact (single damping structure).

As may be understood from the above, the association of the damping and stopping structure with movable masses such as those of the gyroscope 1 is only an example embodiment. The damping and stopping structure of the present invention may in fact be used in any other MEMS device comprising one or more movable masses having frame portions able to accommodate the same damping and stopping structure and having a relative degree of freedom with respect to even just one direction of motion (be it a sensing or driving direction).

Finally, it is clear that modifications and variations may be made to what has been described and illustrated herein without thereby departing from the scope of the present invention, as defined in the attached claims.

For example, a damping and stopping structure may be associated not with all the pitch sensing masses but only with one of the pitch sensing masses per pair.

The "T-shaped" damping and stopping structure, for example, may not be symmetrical with respect to the first anchor, i.e. the first anchor may be arranged in a decentralized position in the opening and therefore second elongated elements of distinct groups may have lengths different from each other. Furthermore, second elongated elements of the first group may be misaligned with respect to second elongated elements of the second group; similarly, first elongated elements of the first group may be misaligned with respect to first elongated elements of the second group.

In an embodiment not shown, the damping and stopping structure may have a symmetrical shape with respect to an axis parallel to the X-axis and passing centrally to the damping and stopping structure. In such a case, the damping and stopping structure comprises a further second anchor, opposite to the second anchor previously described and which is similar thereto in shape and functionality. For example, it is possible to have a damping and stopping structure wherein the first anchor and the second anchors form an "H-shaped" structure, or a damping and stopping structure wherein the first anchor and the second anchors form a "C-shaped" structure.

In a further embodiment not shown, in a damping and stopping structure similar to the damping and stopping structure of Figure 3, the first anchor comprises first anchor portions separated from each other, aligned along the Y-axis and each anchored to the support body. Corresponding second elongated elements of the first group and the second group extend from each of the first anchor portions. Such a variant may also concern a damping and stopping structure similar to the damping and stopping structure of Figure 4.

The stopping elements may be different from the bumper shape described and shown, while still fulfilling the stopping function along at least one of the directions of motion of the movable mass.

## Claims

1. A microelectromechanical device (1) comprising:
- a support body (2);
- a movable mass (Y4), constrained to the support body (2) with a relative degree of freedom with respect to at least a first direction (Y) parallel to the support body (2), and comprising a frame portion (6) delimiting an opening (7); and
- a damping and stopping structure (5; 105), anchored to the support body (2) and accommodated in the opening (7) of the movable mass (Y4),
wherein the movable mass (Y4) comprises a plurality of first elongated elements (65) defined by respective plates perpendicular to the first direction (Y) and extending in the opening (7) from the frame portion (6) in a comb-like configuration,
wherein the damping and stopping structure (5; 105) comprises a plurality of second elongated elements (55; 155) anchored to the support body (2), defined by respective plates perpendicular to the first direction (Y) and extending towards the frame portion (6) of the movable mass (Y4) in a comb-like configuration, the second elongated elements (55; 155) being interdigitated with the first elongated elements (65), and
wherein the damping and stopping structure (5; 105) further comprises a plurality of stopping elements (56; 156) configured to limit movements of the movable mass (Y4) along at least the first direction (Y).

2. The device (1) according to claim 1, wherein the first elongated elements (65) are rigidly fixed to the movable mass (Y4) and wherein the first elongated elements (65) and the second elongated elements (55; 155) form a viscous damper for the movable mass (Y4) along the first direction (Y).

3. The device (1) according to claim 1 or 2, the device (1) being a gyroscope and the movable mass (Y4) having a further relative degree of freedom with respect to a second direction (X) parallel to the support body (2) and perpendicular to the first direction (Y),
wherein the device (1) further comprises an actuator (D1-D4) configured to maintain the movable mass (Y4) in oscillation along the second direction (X) and wherein the movable mass (Y4) is constrained to the support body (2) so as to oscillate along the first direction (Y) in response to a rotation around a rotation axis (Z) perpendicular to the support body (2).

4. The device (1) according to any of the preceding claims, wherein the stopping elements (56; 156) of the damping and stopping structure (5; 105) comprise contact portions protruding towards the frame portion (6) of the movable mass (Y4).

5. The device (1) according to any of the preceding claims, wherein the damping and stopping structure (5; 105) comprises a first anchor (51; 151) of elongated shape parallel to the first direction (Y), the second elongated elements (55; 155) being supported by the first anchor (51; 151).

6. The device (1) according to the preceding claim, wherein the damping and stopping structure (5; 105) further comprises a second anchor (52; 152) of elongated shape parallel to a second direction (X) parallel to the support body (2) and perpendicular to the first direction (Y).

7. The device (1) according to the preceding claim, wherein the stopping elements (56; 156) of the damping and stopping structure (5; 105) protrude towards the frame portion (6) of the movable mass (Y4) from a respective one of the first anchor (51; 151) and the second anchor (52; 152).

8. The device (1) according to claim 6 or 7, wherein the first anchor (51; 151) and the second anchor (52; 152) form a single body.

9. The device (1) according to any of claims 6 to 8, wherein the first anchor (51; 151) of the damping and stopping structure (5; 105) extends substantially parallel to first sides (61, 62) of the frame portion (6) of the movable mass (Y4) opposite to each other along the second direction (X) and wherein the second anchor (52; 152) extends substantially parallel to second sides (63, 64) of the frame portion (6) opposite to each other along the first direction (Y) .

10. The device (1) according to the preceding claim, wherein the plurality of first elongated elements (65) of the movable mass (Y4) comprises a first group (651) of first elongated elements (65) and a second group (652) of first elongated elements (65), the first elongated elements of the first group (651) and the first elongated elements of the second group (652) extending from respective first sides (61, 62) of the frame portion (6),
wherein the first anchor (51) of the damping and stopping structure (5) is arranged between, and at a distance from, the first group (651) of first elongated elements (65) and the second group (652) of first elongated elements (65), and wherein the plurality of second elongated elements (55) of the damping and stopping structure (5) comprises a first group (551) of second elongated elements (55) and a second group (552) of second elongated elements (55), the second elongated elements of the first group (551) and the second elongated elements of the second group (552) extending from respective sides (511, 512) of the first anchor (51) opposite to each other along the second direction (X), and
wherein the second elongated elements of the first group (551) are interdigitated with the first elongated elements of the first group (651) and the second elongated elements of the second group (552) are interdigitated with the first elongated elements of the second group (652).

11. The device (1) according to the preceding claim, wherein each first elongated element of the first group (651) is aligned, along the second direction (X), with a respective first elongated element of the second group (652) and wherein each second elongated element of the first group (551) is aligned, along the second direction (X), with a respective second elongated element of the second group (552).

12. The device (1) according to claim 10 or 11, wherein the first anchor (51) is arranged substantially centrally in the opening (7) of the movable mass (Y4), and wherein the second anchor (52) comprises two arms (521) extending from opposite sides with respect to an end of the first anchor (51) and arranged adjacent to one (63) of the second sides (63, 64) of the frame portion (6) of the movable mass (Y4).

13. The device (1) according to any of claims 10 to 12, wherein the plurality of stopping elements (56) comprises first stopping elements (561), protruding from the first anchor (51), and second stopping elements (562), protruding from the second anchor (52), the second stopping elements (562) and the first stopping elements (561) protruding towards respective second sides (63, 64) of the frame portion (6).

14. The device (1) according to claim 9, wherein the first elongated elements (65) of the movable mass (Y4) extend from one (62) of the first sides (61, 62) of the frame portion (6) and wherein the second elongated elements (155) of the damping and stopping structure (105) extend from one side (612) of the first anchor (151) facing said one (62) of the first sides (61, 62) of the frame portion (6), and
wherein the first anchor (151) is arranged adjacent to the other (61) of the first sides (61, 62) of the frame portion (6) and wherein the second anchor (152) is arranged adjacent to one (63) of the second sides (63, 64) of the frame portion (6).

15. The device (1) according to the preceding claim, wherein the plurality of stopping elements (156) comprises first stopping elements (661), protruding from the first anchor (151) towards the said other (61) of the first sides (61, 62) of the frame portion (6), and second stopping elements (662), protruding from the second anchor (152) towards the said one (63) of the second sides (63, 64) of the frame portion (6), the first stopping elements (661) being configured to limit movements of the movable mass (Y4) along the second direction (X) and the second stopping elements (662) being configured to limit movements of the movable mass (Y4) along the first direction (Y).
